# EUROPEAN PATENT APPLICATION

(11) **EP 4 618 160 A1**
(43) Date of publication of application: **17.09.2025**
(21) Application number: 24305364.2
(22) Date of filing: 11.03.2024
(51) Int. Cl.: H01L 29/94, H01G 4/008, H01G 4/012, H01G 4/08, H01G 4/33

(54) **ELECTRICAL DEVICE FOR HIGH VOLTAGE APPLICATIONS**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: BUFFLE, Larry, 38000 GRENOBLE (FR); VOIRON, Frédéric, 38530 BARRAUX (FR); SOULIER, Brigitte, 38000 GRENOBLE (FR); ARCHAMBAULT, Sophie, 38054 GRENOBLE CEDEX 09 (FR); LAURANT, Christine, 38054 GRENOBLE CEDEX 09 (FR)
(74) Representative: Cabinet Beau de Loménie

(57) **Abstract**

The proposed invention relates to an electrical device (100) comprising a capacitor including:
- a bottom electrode (110) comprising a conductive structure, the conductive structure having a base surface (BS) and protruding walls (111), wherein the base surface (BS) of the conductive structure of the bottom electrode (110) is lower than a top surface of the protruding walls (111) and the base surface (BS) surrounds the protruding walls (111);
- a dielectric structure (120) extending conformally over the bottom electrode (110);
- a top electrode (130) extending conformally over the dielectric structure (120) and comprising a stack of layers including a first conductive layer (131) and a second conductive layer (132), wherein the second conductive layer (132) has an opposite mechanical stress compared to an mechanical stress induced by the first conductive layer (131) and the dielectric structure (120).

## Description

### Field of the invention

The present invention relates to the field of electrical devices, and more precisely to capacitive devices used in high voltage applications.

### Description of Related Art

Capacitors with three-dimensional (3D) capacitive structures have been developed in view of providing high energy storage density. Typically, such 3D capacitive structures are formed conformally on reliefs (*e.g*., pores, holes, trenches, or pillars) and provide a large specific area for a given component size.

The use of electrical components with 3D capacitive structures for high voltage applications (*e.g*., exceeding 400V, 600V, 900V or 1,200V) requires adapting them to the specific features and constraints of these applications. In particular, it is necessary to use 3D capacitive structures with significantly thicker dielectric layers to withstand high voltages.

However, when manufacturing electrical components with 3D capacitive structures for high voltage applications using semiconductor wafers, a large wafer bow has been observed. That is, a substantial vertical deviation is observed between the center of the wafer and the edges of the wafer. Such a wafer bow has multiple negative consequences. In particular, the wafer may be bowed to such an extent that it can no longer be manipulated by robotic tools (the robotic handling limit is generally around ± 150µm of bow), which may result in a manufacture interruption.

The wafer bow and its negative consequences have long been an obstacle to the manufacture of electronic components with high energy storage density for high voltage applications. One of the solutions envisaged in the current state of the art for reducing the wafer bow consists in using larger distances between the reliefs of the 3D capacitive structure. However, such a solution necessarily results in a reduced energy storage density.

Therefore, there exists a need for a solution that enables to manufacture electrical devices with high energy storage density and suited to high voltage applications, while limiting the wafer bow.

### Summary of the invention

The present invention has been made in the light of the above problems.

According to an aspect, the present invention provides an electrical device comprising a capacitor including:
- a bottom electrode comprising a conductive structure, the conductive structure having a base surface and protruding walls extending upwards from the base surface, wherein the base surface of the conductive structure of the bottom electrode is lower than a top surface of the protruding walls and the base surface surrounds the protruding walls;
- a dielectric structure extending conformally (it conforms to the protruding walls) over the bottom electrode;
- a top electrode extending conformally (it conforms to the protruding walls covered with the dielectric structure) over the dielectric structure and comprising a stack of layers including a first conductive layer and a second conductive layer (i.e. the first conductive layer is above the second conductive layer in the stack or the second conductive layer is above the first conductive layer in the stack), wherein the second conductive layer has an opposite intrinsic mechanical stress compared to an intrinsic mechanical stress induced by the first conductive layer and the dielectric structure.

The present invention proposes combining an open 3D structure and a multi-layer composite top electrode in order to limit the wafer bow during the manufacture of the electrical device.

On the one hand, the proposed electrical device uses an open 3D structure. To describe this structure, we consider here an example in which the conductive structure of the bottom electrode is formed by a semiconductor substrate having a base surface and protruding walls that extend above the base surface of the substrate. Specifically, the base surface of the substrate is lower than the top surface of the protruding walls and surrounds them. As such, the protruding walls form a protruding structure with respect to the base surface of the substrate. The 3D capacitive structure of the electrical device is then formed conformally on the protruding walls.

The 3D structure used in the proposed solution is referred to as *an open 3D structure.* It differs from 3D structures formed by recesses extending downwards from the top surface of a substrate, which can be referred to as *closed 3D structures.* In contrast to a closed 3D structure in which the substrate is globally thick (except at the level of the recesses), an open 3D structure is globally thin (except at the level of the protruding walls) and therefore significantly less rigid.

On the other hand, the proposed electrical device uses a multi-layer composite top electrode. More specifically, the second conductive layer presents an opposite mechanical tension compared to the mechanical tension induced by the first conductive layer and the dielectric structure. In other words, the second conductive layer counteracts the deformation induced by the first conductive layer and the dielectric structure.

The combination of an open 3D structure with a multi-layer composite top electrode is particularly advantageous. Since the side with the open 3D structure is significantly less rigid, it allows the multi-layer composite top electrode to control the deformation of the wafer.

The inventors have observed that the proposed solution results in a significant reduction of the wafer bow during the manufacture of the proposed electrical device, especially just after the electrode deposition step which nearly completely fills the open structure. By limiting the wafer bow, the proposed solution also ensures that the wafer can be handled by robotic tools (i.e., the wafer bow remains below the robotic handling limit).

For these reasons, the proposed solution allows using a 3D capacitive structure with a large specific area *(i.e.,* a dense 3D structure leading to a high capacitance) and a thick dielectric, while ensuring that the wafer bow remains limited. The present invention hence provides an electrical device with high energy storage density and suited to high voltage applications, while limiting the wafer bow during its manufacture.

In a particular embodiment, the base surface of the conductive structure of the bottom electrode forms a continuous trench that extends between the protruding walls of the conductive structure and surrounds the protruding walls.

In this embodiment, the base surface of the conductive structure forms a single continuous trench that not only separates the protruding walls of the conductive structure from one another, but also that surrounds them. In other words, a single continuous trench extends between each pair of adjacent protruding walls and surrounds the protruding walls.

This embodiment proposes using an open 3D structure defined by a continuous trench to form the capacitor of the electrical device. The use of such an open 3D structure formed by a continuous trench provides numerous electrical and mechanical improvements.

In particular, this embodiment provides a 3D structure with a large specific area, and therefore an electrical device with a high energy storage density. The 3D structure proposed in this embodiment also presents a low rigidity, which contributes to reducing the mechanical stress within the structure and facilitates controlling the wafer bow.

In a particular embodiment, the second conductive layer of the top electrode extends over the first conductive layer of the top electrode and seals regions (*e.g*., trenches) between the protruding walls.

In this embodiment, the second conductive layer of the top electrode seals the 3D structure. That is, the top surface of the second conductive layer lies above the top surface of the protruding walls.

This embodiment is particularly advantageous with regard to manufacturing and electrical performance concerns. In particular, by sealing the 3D structure, the second conductive layer protects the 3D structure and prevents it from being exposed to potentially damaging chemicals during subsequent manufacturing steps. It also advantageously provides a substantially flat surface, on which additional layers can be easily deposited.

It should be noted that the regions (*e.g*., the trenches) between the protruding walls can be filled completely or partially, both configurations being possible. These regions can be filled by the first conductive layer, with the second conductive layer extending over it. Alternatively, the first conductive layer may only partially fill the regions between the protruding walls, and the second conductive layer may fill these regions and seal the 3D structure. Finally, the second conductive layer can also seal the 3D structure while leaving an unfilled space between the protruding walls, i.e. a void.

In a particular embodiment, the second conductive layer of the top electrode seals the regions (*e.g*., trenches) between the protruding walls such that one or more spaces between the protruding walls remain unfilled.

In this embodiment, the first conductive layer only partially fills the regions between the protruding walls (*e.g*., trenches). The second conductive layer extends on the first conductive layer so as to seal the 3D structure without filling the regions between the protruding walls. In others words, the second conductive layer seals the 3D structure while leaving unfilled spaces (*i.e*., voids) between the protruding walls.

This embodiment is advantageous in that it prevents mechanical stress from building up within the 3D structure, while sealing it for manufacturability and electrical performance concerns.

In a particular embodiment, the first conductive layer of the top electrode comprises polysilicon, and the second conductive layer of the top electrode comprises tungsten and extends on the first conductive layer.

The advantage of this embodiment is that the proposed electrical device can be easily obtained using conventional manufacturing techniques. The use of a polysilicon layer (*e.g*., a low-stress polysilicon layer) is particularly advantageous as it can be easily deposited within a 3D structure using Low Pressure Chemical Vapor Deposition (LPCVD) and allows filling (fully or partially) the 3D structure. Further, a tungsten layer (*e.g*., a tensile tungsten layer) can be easily deposited by Chemical Vapor Deposition (CVD), and allows controlling the mechanical stress in the 3D structure and limiting the wafer bow. This embodiment allows the wafer bow to be significantly reduced while using conventional manufacturing techniques.

In a particular embodiment, the second conductive layer of the top electrode is thinner than the first conductive layer of the top electrode.

This embodiment allows depositing a first conductive layer conformally to the 3D structure to form the main part of the top electrode, and then depositing a thin second conductive layer to reduce the wafer bow. The deposition of such thin second conductive layer is advantageous in that it can be performed rapidly and allows the wafer bow to be significantly reduced.

In a particular embodiment, a thickness of the second conductive layer of the top electrode is comprised between 50nm and 1,000nm.

The inventors have observed that such an embodiment enables effectively controlling the wafer bow by using a second conductive layer of relatively small thickness. In other words, this embodiment allows the wafer bow to be significantly reduced using a single deposition step of a thin conductive layer (*i.e*., a fast deposition).

In a particular embodiment, the conductive structure of the bottom electrode is (or comprises) a silicon substrate. Alternatively, other embodiments could be envisaged wherein other types of substrates or structures are used to form the bottom electrode.

In a particular embodiment, the electrical device is configured to be used with an operating voltage measured between the bottom and top electrodes exceeding 400V, 600V, 900V or 1,200V. For instance, the proposed electrical device may be used as a decoupling or snubber capacitive element for power electronic.

According to another aspect, the present invention provides a method for manufacturing an electrical device comprising a capacitor, said method comprising:
- forming a bottom electrode comprising a conductive structure, the conductive structure having a base surface and protruding walls that extend upwards from the base surface, wherein the base surface of the conductive structure is lower than a top surface of the protruding walls and the base surface surrounds the protruding walls;
- forming a dielectric structure conformally over the bottom electrode; and
- forming a top electrode conformally over the dielectric structure, the top electrode comprising a stack of layers including a first conductive layer and a second conductive layer, wherein the second conductive layer has an opposite intrinsic mechanical stress compared to a mechanical stress of the first conductive layer and the dielectric structure.

The proposed manufacturing method can be adapted to obtain any one of the electrical devices defined in the present disclosure. Further, it should be noted that the embodiments of the proposed method for manufacturing an electrical device present the advantages described in relation with the embodiments of the proposed electrical device.

In a particular embodiment, the proposed manufacturing method comprises a preliminary step of selecting the second conductive layer of the top electrode based on: an intrinsic mechanical stress of the dielectric structure; and an intrinsic mechanical stress of the first conductive layer of the top electrode.

In a particular embodiment, the step of forming the bottom electrode comprises: etching a continuous trench that extends between the protruding walls and surrounds them.

In a particular embodiment, the second conductive layer of the top electrode extends over the first conductive layer of the top electrode and seals regions between the protruding walls.

In a particular embodiment, the first conductive layer of the top electrode comprises polysilicon, and the second conductive layer of the top electrode comprises tungsten and extends on the first conductive layer.

### Brief Description of the Drawings

Further features and advantages of the present invention will become apparent from the following description of certain embodiments thereof, given by way of illustration only, not limitation, with reference to the accompanying drawings in which:
FIG. 1A-1C illustrate an electrical device according to an embodiment outside the scope of the invention and the wafer bow evolution during the manufacturing of this electrical device;
FIG. 2A-2C illustrate an electrical device according to an embodiment of the invention and the wafer bow evolution during the manufacturing of this electrical device;
FIG. 3A-3E illustrate steps of a method for manufacturing an electrical device according to embodiments of the invention;
FIG. 4A-4C are SEM images of cross-section views of electrical devices according to embodiments of the invention; and
FIG. 5 is a SEM image of a 3D structure of an electrical device according to an embodiment of the invention.

### Detailed Description of Example Embodiments

Embodiments of the present invention provide an electrical device with a high energy storage density and suited to high voltage applications. More specifically, embodiments of the present invention seek to limit the wafer bow when manufacturing such an electrical device.

The present invention applies in particular to electrical devices using 3D capacitive structures formed using trenches. The following description of the invention will refer to this particular application, which is only given as an illustrative example. The present invention also applies to 3D capacitive structures based on pillars.

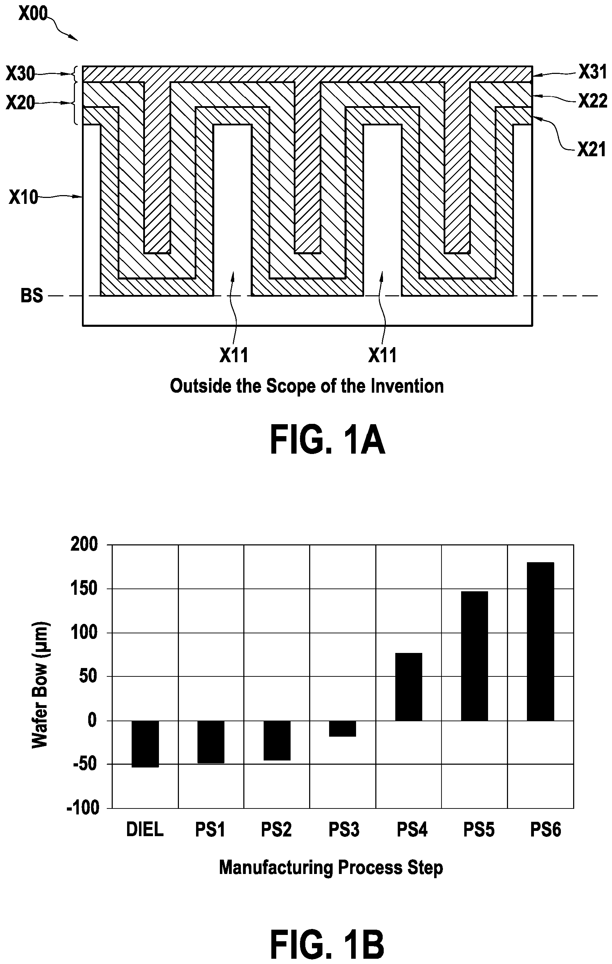

**FIG. 1A-1C** illustrate an electrical device according to an embodiment outside the scope of the invention and the wafer bow evolution during the manufacturing of this electrical device. These figures are described below to present the inventors' experiments and observations on which the present invention relies.

Hereinafter, the wafer bow is defined as the vertical deviation between the center of the wafer and the edges of the wafer. It characterizes the flatness of the wafer.

FIG. 1A illustrates a side cross-section view of an electrical device X00 according to an embodiment outside the scope of the invention.

The electrical device X00 illustrated in FIG. 1A comprises a capacitor formed by a bottom electrode X10 and a top electrode X30 separated by a dielectric structure X20.

More specifically, the bottom electrode X10 comprises a conductive structure having a base surface BS and protruding walls X11 that extend upwards from the base surface BS. For instance, the bottom electrode X10 may be formed by etching one or more trenches in a doped silicon substrate.

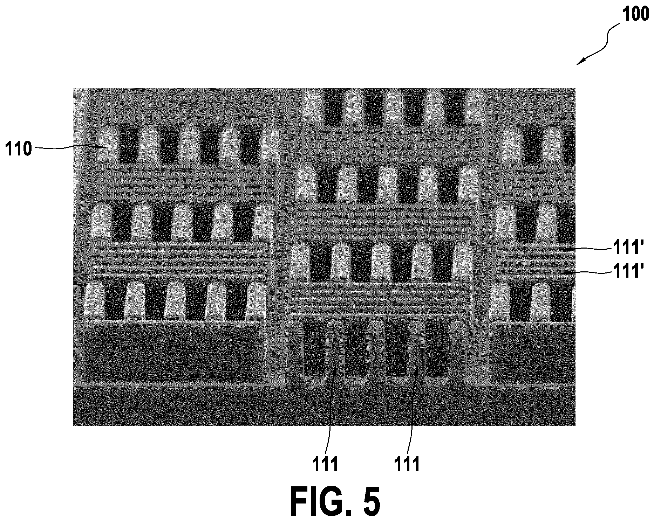

It should be emphasized that the base surface BS of the conductive structure of the bottom electrode X10 is lower than the top surface of the protruding walls X11 and the base surface BS surrounds the protruding walls X11. This conductive structure defines an open 3D structure with reduced rigidity. Such an open 3D structure is illustrated by FIG. 5 and is further detailed in reference to this figure.

The dielectric structure X20 illustrated in this figure extends conformally over the bottom electrode X10. It comprises a first dielectric layer X21 (*e.g.,* an SiO₂ layer) and a second dielectric layer X22 (*e.g*., an Si₃N₄ layer). For high voltage applications, the thickness of the dielectric structure X20 is typically superior to 1 or 2µm. Such multi-layer dielectric structure X20 may be advantageous to adjust its dielectric strength and adherence to the bottom electrode X10.

As for the top electrode X30, it consists here of a single conductive layer X31 (*e.g*., a polysilicon layer). This layer X31 fills the regions between the protruding walls X11.

The structure illustrated here provides an electrical device X00 with a high energy storage density and suited to high voltage applications. However, as shown in the following figure, the manufacture of this electrical device X00 results in an important wafer bow.

FIG. 1B illustrates the wafer bow evolution during the manufacture of the electrical device X00 according to an embodiment outside the scope of the invention.

This figure illustrates the evolution of the wafer bow at the end of the different manufacturing steps of the electrical device X00. Step DIEL corresponds to the deposition of the dielectric structure X20, and steps PS1-PS6 correspond to successive depositions of material to form the top electrode X30. In the experiments conducted by the inventors, the top electrode X30 was formed by a layer X31 of polysilicon deposited by LPCVD at around 600°C.

It should first be noted that, up to the deposition of the dielectric structure X20 (step DIEL), the deformation of the wafer remains low and does not prevent an automatic handling of the wafer. However, as more and more material is deposited to form the top electrode X30 (steps PS1-PS6), the wafer bow increases gradually and finally exceeds 150µm at the end of this manufacturing process, which prevents an automatic handling of the wafer.

The inventors' experiments have shown that the deformation of the wafer increases when the top electrode X30 is thick enough to bind laterally the sides of the 3D structure (*i.e.,* to bind the protruding walls X11). When the wafer is then cooled to ambient temperature, the conductive layer X31 presents a compressive stress and deforms the wafer into a convex shape (*i.e*., the center of the wafer lies above its edges).

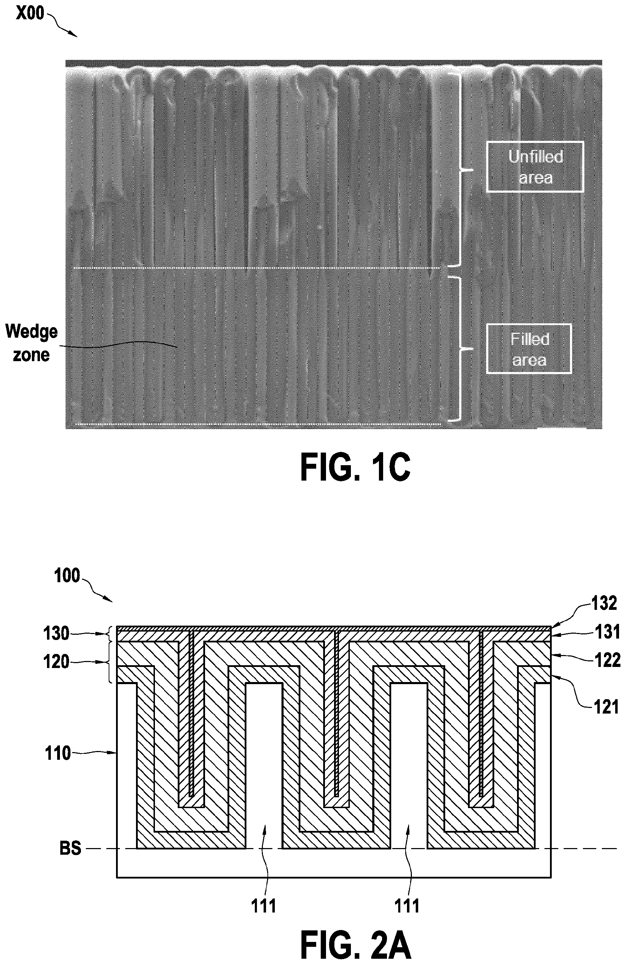

In other words, the conductive layer X31 acts as a "wedge" exerting a significant mechanical stress that deforms the wafer. The SEM image in FIG. 1C illustrates the area where the top electrode fills the regions between the protruding walls and acts as a wedge.

The deformation of the wafer is mainly driven by its front side (with the protruding walls). The direction and amplitude of this deformation depend on the type of 3D structure used, the thickness and type of dielectric, the deposition technique and temperature used, etc. It follows that the wafer may be deformed beyond the limit allowing further handling by robotic tools (typically, around ±150µm), which may result in a manufacture interruption.

We describe below how the present invention allows limiting the wafer bow when manufacturing an electrical device with high energy storage density and suited to high voltage applications.

**FIG. 2A-2C** illustrate an electrical device according to an embodiment of the invention and the wafer bow evolution during the manufacture of this electrical device. These figures are described to introduce the present invention and present an example embodiment.

FIG. 2A illustrates a side cross-section view of an electrical device 100 according to an embodiment of the invention.

The electrical device 100 differs from the previously presented electrical device X00 by its top electrode 130. The top electrode 130 of the electrical device 100 comprises a stack of layers including a first conductive layer 131 and a second conductive layer 132.

The second conductive layer 132 has an opposite intrinsic mechanical stress compared to the mechanical stress induced by the first conductive layer 131 and the dielectric structure 120. The use of such a multi-layer composite top electrode 130 allows limiting the wafer bow.

The stress direction (*i.e*., compressive or tensile) of the second conductive layer 132 can be adjusted with regard to the intrinsic stress of the first conductive layer 131 and the intrinsic stress of the dielectric structure 120.

From tungsten (W) with tensile stress to titanium nitride (TiN) with compressive stress, various strategies and stacks can be used according to the deformation direction and the residual space between the protruding walls 111 to be filled.

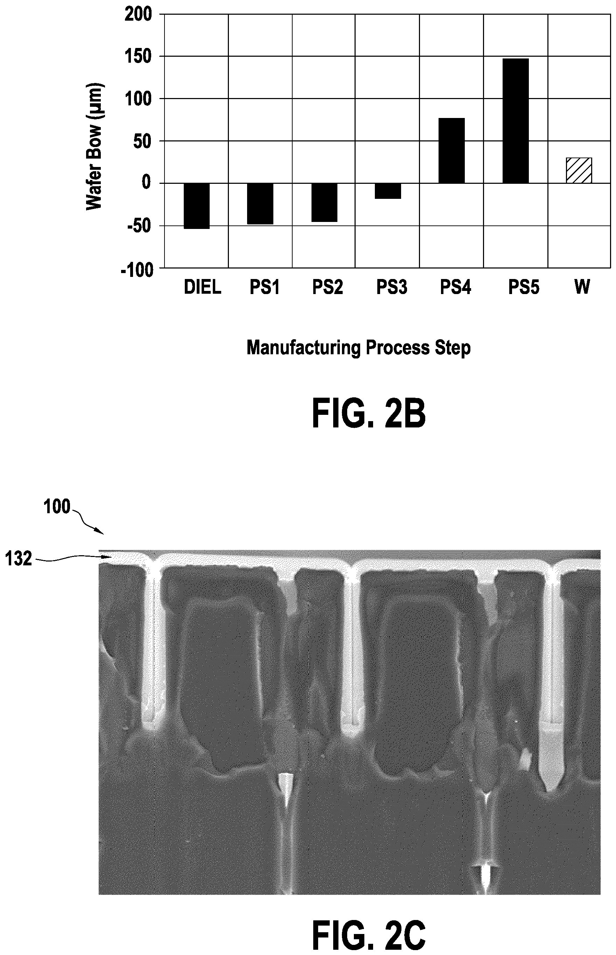

FIG. 2B illustrates the wafer bow evolution during the manufacture of the electrical device 100. This figure shows the benefits of using the proposed multi-layer composite top electrode structure 130.

In comparison to the manufacturing process previously described in reference to FIG. 1A-1C, the manufacturing process illustrated here does not end by performing the step PS6 of deposition material forming the first conductive layer 131. Instead, it ends by a distinct deposition step noted W to form the second conductive layer 132.

In the experiments of the present figure, the second conductive layer 132 was a tungsten (W) layer with a tensile stress. The second conductive layer 132 is used to compensate the compressive stress induced by the first conductive layer 131 made of polysilicon and the dielectric structure 120.

In these experiments, the temperature used for depositing the polysilicon layer 131 is comprised between 600°C and 900°C and the temperature used for depositing the tungsten layer 132 is comprised between 400°C and 500°C. The intrinsic stress of the polysilicon layer 131 is comprised between 10MPa and 30MPa, whereas the intrinsic stress of the tungsten layer is around 1GPa. Here, the thickness of the polysilicon layer 131 is approximately 1,000 nm (each of the PS1-PS5 deposition steps corresponds to the deposition of 200 nm of polysilicon) and the thickness of the tungsten layer 132 is approximately 450 nm. However, the present invention is not limited to the particular values used in these experiments, which are given here by way of example only.

As illustrated in FIG. 2B, the inventors' experiments have shown that combining an open 3D structure (with a reduced rigidity) and a multi-layer composite top electrode has numerous advantages. Most importantly, this results in a significant reduction in the wafer bow: from around 175µm in FIG. 1B down to around 30µm here. The proposed solution allows limiting the wafer deformation.

Furthermore, the use of the second conductive layer 132 not only reduces the overall wafer deformation, but also seals the 3D capacitive structure. As shown in the SEM picture of FIG. 2C, the 3D capacitive structure is sealed (for example, completely) by the second conductive layer 132. Here, sealing means that the regions between facing protruding walls 111 are closed at the level of their top surface by the second conductive layer 132. By sealing the 3D structure, the second conductive layer 132 prevents it from being exposed to potentially damaging chemicals during subsequent manufacturing steps.

By limiting the wafer bow, the proposed solution allows the wafer to be handled by robotic tools.

The proposed solution hence allows obtaining an electrical device 100 with high energy storage density (*i.e*., a dense 3D structure) and suited to high voltage applications (*i.e*., with a thick dielectric), while limiting the wafer bow during the manufacture of this electrical device.

We have introduced above the structure of the proposed electrical device 100, and how it allows limiting the wafer bow. We will now further detail the method for manufacturing the electrical device 100.

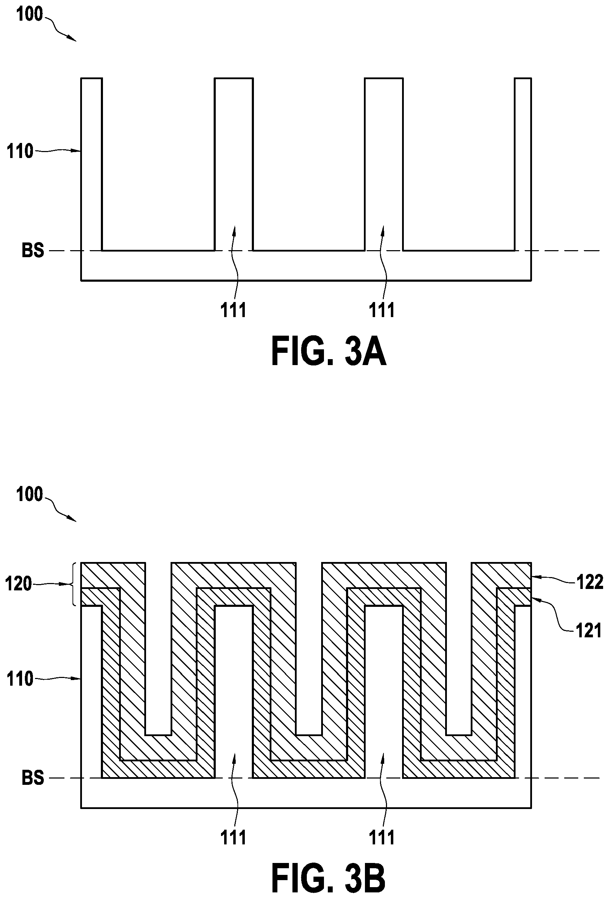

**FIG. 3A-3E** illustrate steps of a method for manufacturing an electrical device according to embodiments of the invention.

The method for manufacturing the proposed electrical device 100 comprises (all or part of) the following steps described hereinafter.

In FIG. 3A, a step is shown in which the bottom electrode 110 is formed. The bottom electrode 110 comprises a conductive structure having a base surface BS and facing protruding walls 111 that extends upwards from the base surface BS.

Specifically, the base surface BS of the conductive structure of the bottom electrode 110 is lower than the top surface of the protruding walls 111 and the base surface BS surrounds the protruding walls 111 (as illustrated in FIG. 5). This conductive structure defines an open 3D structure with reduced rigidity. We further detail this structure in reference to FIG. 5.

The conductive structure 110 may be formed by etching a semiconductor substrate (*e.g*., a doped silicon substrate). The conductive structure 110 may also be formed by an etched substrate (*e.g*., a substrate comprising glass or a polymer material) comprising protruding walls 111 and a metal layer (or a conductive layer) deposited so as to be extending conformally over the etched substrate.

In a particular embodiment, the base surface BS of the conductive structure 110 forms a single continuous trench (*e.g*., a meander shape trench) that not only separates the protruding walls 111 from one another, but also that surrounds them. This embodiment is further detailed in reference to FIG. 5. Other embodiments wherein the protruding walls 111 form a plurality of separate trenches could also be envisaged.

The protruding walls 111 can extend in a (substantially) linear or curved manner. In other words, the protruding walls 111 may present: a (substantially) linear shape; or a curved shape, or a combination of linear shapes with turns/curves in between. In the curved case, to prevent local increases of the electrostatic field in the capacitor, the curvature radius of curved protruding walls 111 may be greater than twice a thickness of the dielectric structure 120 (*e.g*., the thickness of the dielectric between the electrodes).

The corners (for example, every corner) of the protruding walls 111 can be rounded (as illustrated in FIG. 5). This allows maintaining a low magnitude electrostatic field within the capacitive structure. For instance, isotropic dry etching may be used to consume the sharp edges of the protruding walls 111 after preliminary walls have been formed.

In FIG. 3B, a step is shown in which the dielectric structure 120 is formed on the bottom electrode 110.

Here, the dielectric structure 120 comprises a first dielectric layer 121 and a second dielectric layer 122 that extends conformally over the protruding walls 111.

For instance, the first dielectric layer 121 may comprise silicon oxide (SiO₂) and may be 1µm or 2µm thick. The second dielectric layer 121 may comprise silicon nitride (Si₃N₄) or alumina (Al₂O₃) and may be 1µm or 2µm thick. Such a bi-layer dielectric structure is advantageous in that it presents a high permittivity and a strong adherence to the bottom electrode 110.

Forming the dielectric structure 120 can hence comprise a step in which an oxide layer 121 is formed by oxidizing the conductive structure 110. It may further comprise a step in which the dielectric layer 122 is formed on the conductive structure 110 using LPCVD or Atomic Layer Deposition (ALD).

Within the scope of the invention, it could also be envisaged embodiments wherein the dielectric structure comprises a single dielectric layer, or more than two dielectric layers.

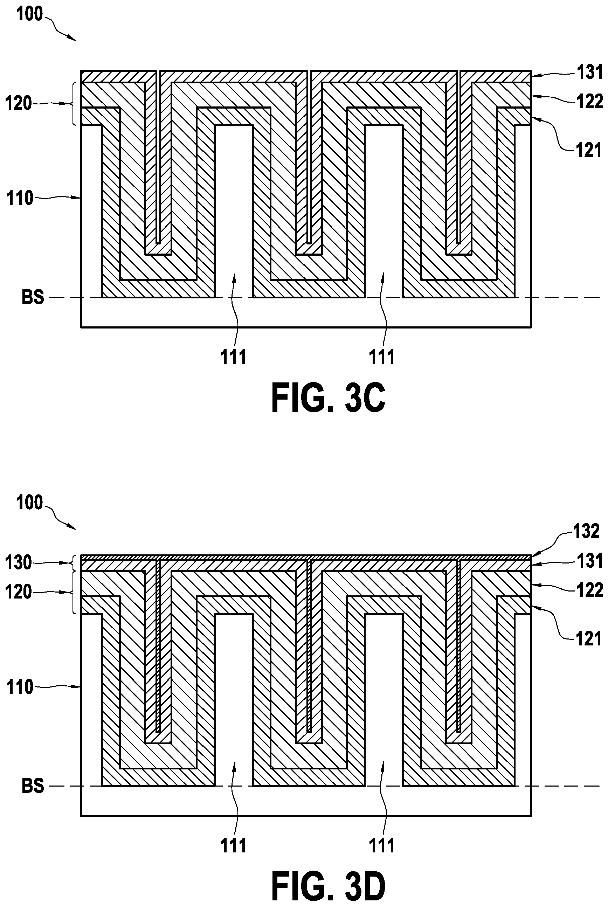

In FIG. 3C, a step is shown in which the first conductive layer 131 is deposited so as to extend conformally over the dielectric structure 120.

The first conductive layer 131 can be made of any conductive or semi-conductive material compatible with deposition. In a particular embodiment, the first conductive layer 131 may be formed of polysilicon deposited by LPCVD. Preferably, the first conductive layer 131 is a low stress layer. It can be compressive or tensile.

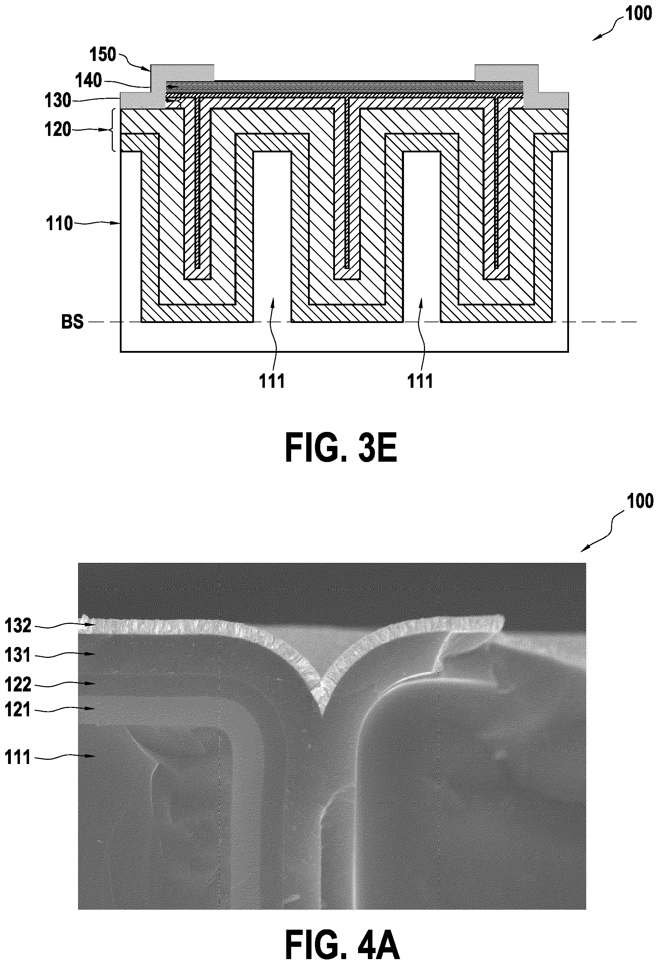

The first conductive layer 131 may fully or partially (as illustrated here) fill the regions between the protruding walls 111, but this aspect is further detailed in reference to FIG. 4A-4C.

In FIG. 3D, a step is shown in which the second conductive layer 132 is deposited.

The second conductive layer 132 can be made of any conductive or semi-conductive material compatible with deposition. In particular, metals can be used to form the second conductive layer 132 since they can be easily deposited by CVD. The second conductive layer 132 may thus be formed of tungsten (W) or titanium nitride (TiN) deposited by CVD.

Within the scope of the invention, it could also be envisaged that the second conductive layer 132 comprises multiple sub-layers and/or materials. For example, it could be formed by 1/3 of tungsten (W) and 2/3 of titanium nitride (TiN). This allows adjusting the mechanical stress of the second conductive layer 132 and also adjusting its thickness to seal the 3D structure. The second conductive layer 132 can also comprise: a liner of titanium nitride (TiN) (for adhesion with the first conductive layer 131), and the remainder in tungsten (W).

In some implementations, the thickness of the second conductive layer 132 is less than the first conductive layer 131, and may lie in the range from 50nm to 1,000nm. This allows the wafer bow to be significantly reduced using a deposition step of a thin conductive layer (*i.e*., a fast deposition).

As illustrated here, the second conductive layer 132 extends over the first conductive layer 131 and seals the regions between the protruding walls 111. That is, the top surface of the second conductive layer 132 lies above the top surface of the protruding walls 111. The regions between facing protruding walls 111 are closed at the level of their top surface by the second conductive layer 132. By sealing the 3D structure, the second conductive layer 132 prevents it from being exposed to potentially damaging chemicals during subsequent manufacturing steps.

The second conductive layer 132 may be deposited down to the bottom of the 3D structure (as shown in this figure), or may also be deposited only partially in the 3D structure. We further detail such embodiments in reference to FIG. 4A-4C.

It should be emphasized that the second conductive layer 132 has an opposite intrinsic mechanical stress compared to the intrinsic mechanical stress induced by the dielectric structure 120 and the first conductive layer 131 (preferably, a low stress layer). In other words, the second conductive layer 132 counteracts the deformation induced by the first conductive layer 131 and the dielectric structure 120. This allows reducing the wafer bow.

For instance, the first conductive layer 131 can be a low stress polysilicon layer, and the second conductive layer 132 can be a tensile tungsten layer. Such layer combination to form the top electrode 130 is advantageous in that the electrical device 100 can be easily obtained using conventional manufacturing techniques. The polysilicon layer can be easily deposited within the 3D structure using LPCVD and allows filling (fully or partially) the 3D structure. And, the tungsten layer can be easily deposited by CVD, and allows reducing the wafer bow.

Thereby, the multi-layer top electrode 130, combining the first conductive layer 131 and the second conductive layer 132, allows limiting the wafer bow when manufacturing the electrical device 100.

Within the scope of the invention, it could also be envisaged embodiments wherein the top electrode 130 comprises a stack of layers including more than two conductive layers.

In FIG. 3E, a step is shown in which an interconnection layer 140 and a passivation layer 150 are deposited.

The interconnection layer 140 is deposited on the top electrode 130. Before depositing the passivation layer 150, the top electrode 130 and the interconnection layer 140 are partially etched as illustrated here.

The present invention is not particularly limited regarding the respective materials used to form the interconnection layer 140 and the passivation layer 150. Typically, the passivation layer 150 is made of a material providing mechanical protection, a moisture diffusion barrier and exhibiting good electrical insulating properties, for example, silicon nitride. The interconnection layer 140 is usually made from aluminum (Al) or copper (Cu), but can also be made of others materials or alloys.

The structure of the electrical device 100 and its manufacturing method have been presented above. However, as previously mentioned, the deposition of the different layers of the top electrode 130 within the 3D structure may be performed according to different embodiments. We detail these embodiments in reference to the following figures.

**FIG. 4A-4C** are SEM images of cross-section views of electrical devices according to embodiments of the invention.

Specifically, these figures illustrate different embodiments for the deposition of the first conductive layer 131 and the second conductive layer 132 of the top electrode 130 within the 3D structure formed by the protruding walls 111.

FIG. 4A illustrates an embodiment wherein the first conductive layer 131 fully fills the regions between the protruding walls 111 (*e.g*., trenches). The second conductive layer 132 is then deposited so as to extend conformally over the first conductive layer 131.

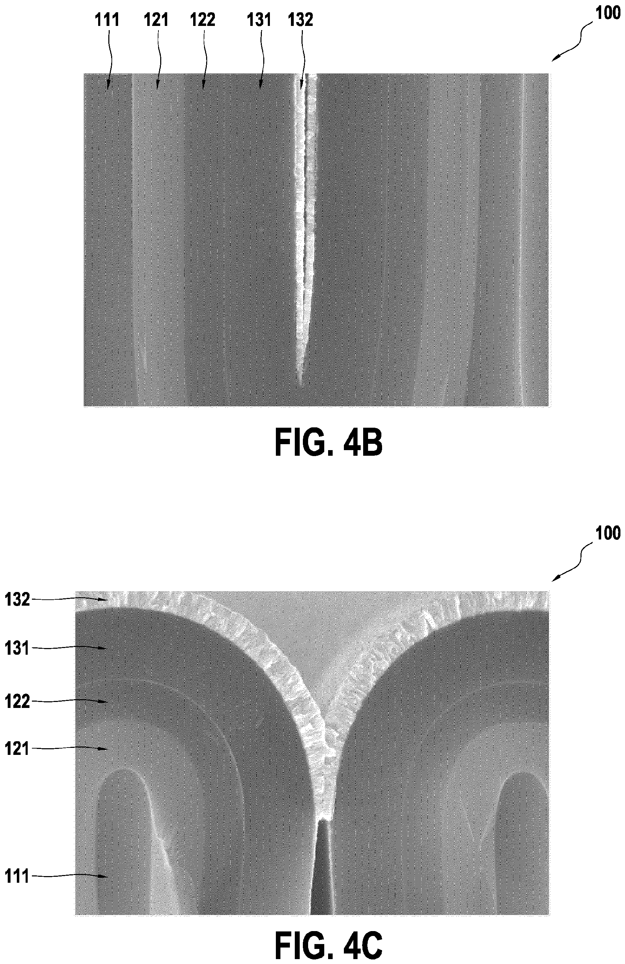

FIG. 4B illustrates an embodiment wherein the first conductive layer 131 partially fills the regions between the protruding walls 111. Here, the second conductive layer 132 is deposited within the unfilled regions between the protruding walls 111 (*i.e*., within the 3D structure).

Such an embodiment presents multiple advantages. The second conductive layer 132 seals the 3D structure and prevents the capacitive area from being exposed to chemicals that may be used later in the manufacturing process (which may compromise the integrity of the dielectric). In addition, since the second conductive layer 132 is deposited within the 3D structure, it enhances the mechanical advantage provided by the multi-layer top electrode 130.

FIG. 4C illustrates an embodiment wherein the first conductive layer 131 fills partially the regions between the protruding walls 111. In this embodiment, the second conductive layer 132 is deposited so as to seal the 3D structure while leaving an unfilled space between the protruding walls 111.

This embodiment is advantageous in that it prevents mechanical stress from building up within the 3D structure, while still sealing it for manufacturability and electrical performance concerns.

We have described here how the top electrode 130 can be deposited in the 3D structure defined by the protruding walls 111. We describe below a particularly advantageous embodiment for the 3D structure of the electrical device 100.

**FIG. 5** is a SEM image of a 3D structure of an electrical device according to an embodiment of the invention. Specifically, this figure illustrates an embodiment wherein the protruding walls 111 are separated and surrounded by a single continuous trench.

We remind that the bottom electrode 110 of the electrical device 100 comprises a conductive structure having a base surface and facing protruding walls 111. The dielectric structure 120 and the top electrode 130 extend conformally over the bottom electrode 110. Hence, the protruding walls 111 define the 3D capacitive structure of the electrical device 100.

The protruding walls 111 form a protrusion with regard to the base surface of the structure. As illustrated here, the base surface of the structure is lower than the top surface of the protruding walls 111, and this base surface surrounds the protruding walls 111. This base surface extends up to the edge of the device 100. The structure proposed in this embodiment can be referred to as an *open 3D structure* and presents the following advantages.

Such an open 3D structure facilitates gas circulation and thus facilitates the deposition of the layers to form the capacitor. This results in easier (*i.e*., faster and more uniform) etching and deposition processes.

It should also be noted that the open 3D structure presents a strong asymmetry between its front side (with the protruding walls) and its rear side. It follows that the rigidity of the structure is significantly reduced. This allows the multi-layer top electrode to easily control the deformation of the wafer.

FIG. 5 also illustrates an embodiment wherein the conductive structure of the bottom electrode 110 may comprise protruding walls 111 and 111' extending in different directions for reducing the mechanical stress.

In this embodiment, the bottom electrode 110 comprises first protruding walls 111 extending along a first direction and second protruding walls 111' extending along a second direction, the first direction and second directions forming a defined angle with each other. The defined angle may be selected or adjusted to reduce mechanical stress within the structure. By way of example, the first direction may be substantially perpendicular to the second direction. However, embodiments are not limited to this implementation and other angle relationships (*e.g*., 10, 20, 30, 60, or 120 degrees) between the first direction and the second direction may be used.

In the example of FIG. 5, a wall region comprising protruding walls 111 arranged along the first direction is surrounded along its sides by walls region comprising protruding walls 111' arranged along the second direction, and vice versa. This symmetric arrangement of wall regions comprising protruding walls 111 and wall regions comprising protruding walls 111' contributes to reducing mechanical stress along the first and second directions.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

In particular, the present invention has been described in reference to a 3D capacitive structure formed using trenches. However, other embodiments of the present invention could be envisaged in which other 3D capacitive structures are used, such as capacitive structures based on pillars (e.g., pillars with a cylinder shape, a tripod shape, or even a triskel shape).

It is to be understood that references in this text to directions and locations, such as "top" and "bottom", "front" and "rear", merely refer to the directions that apply when architectures and components are oriented as illustrated in the accompanying drawings.

## Claims

1. An electrical device (100) comprising a capacitor including:
- a bottom electrode (110) comprising a conductive structure, the conductive structure having a base surface (BS) and protruding walls (111) extending upwards from the base surface (BS), wherein the base surface (BS) of the conductive structure of the bottom electrode (110) is lower than a top surface of the protruding walls (111) and the base surface (BS) surrounds the protruding walls (111);
- a dielectric structure (120) extending conformally over the bottom electrode (110);
- a top electrode (130) extending conformally over the dielectric structure (120) and comprising a stack of layers including a first conductive layer (131) and a second conductive layer (132), wherein the second conductive layer (132) has an opposite intrinsic mechanical stress compared to an intrinsic mechanical stress induced by the first conductive layer (131) and the dielectric structure (120).

2. The electrical device (100) according to claim 1, wherein the base surface (BS) forms a continuous trench that extends between the protruding walls (111) and surrounds them.

3. The electrical device (100) according to claim 1 or 2, wherein the second conductive layer (132) of the top electrode (130) extends over the first conductive layer (131) of the top electrode (130) and seals regions between the protruding walls (111).

4. The electrical device (100) according to claim 3, wherein the second conductive layer (132) of the top electrode (130) seals the regions between the protruding walls (111) such that one or more spaces between the protruding walls (111) remain unfilled.

5. The electrical device (100) according to any of claims 1 to 4, wherein the first conductive layer (131) of the top electrode (130) comprises polysilicon, and the second conductive layer (132) of the top electrode (130) comprises tungsten and extends on the first conductive layer (131).

6. The electrical device (100) according to any of claims 1 to 5, wherein the second conductive layer (132) of the top electrode (130) is thinner than the first conductive layer (131) of the top electrode (130).

7. The electrical device (100) according to any of claims 1 to 6, wherein a thickness of the second conductive layer (132) of the top electrode (130) is comprised between 50nm and 1000nm.

8. The electrical device (100) according to any of claims 1 to 7, wherein the electrical device (100) is configured to be used with an operating voltage measured between the bottom and top electrodes exceeding 400V, or 600V, or 900V or 1200V.

9. A method for manufacturing an electrical device (100) comprising a capacitor, said method comprising:
- forming a bottom electrode (110) comprising a conductive structure, the conductive structure having a base surface (BS) and protruding walls (111) that extend upwards from the base surface (BS), wherein the base surface (BS) of the conductive structure is lower than a top surface of the protruding walls (111) and the base surface (BS) surrounds the protruding walls (111);
- forming a dielectric structure (120) conformally over the bottom electrode (110); and
- forming a top electrode (130) conformally over the dielectric structure (120), the top electrode (130) comprising a stack of layers including a first conductive layer (131) and a second conductive layer (132), wherein the second conductive layer (132) has an opposite intrinsic mechanical stress compared to a mechanical stress of the first conductive layer (131) and the dielectric structure (120).

10. The method according to claim 9, comprising a preliminary step of selecting the second conductive layer (132) of the top electrode (130) based on: an intrinsic mechanical stress of the dielectric structure (120); and an intrinsic mechanical stress of the first conductive layer (131) of the top electrode (130).

11. The method according to claim 10, wherein the step of forming the bottom electrode (110) comprises: etching a continuous trench that extends between the protruding walls (111) and surrounds them.

12. The method according to any of claims 9 to 11, wherein the second conductive layer (132) of the top electrode (130) extends over the first conductive layer (131) of the top electrode (130) and seals regions between the protruding walls (111).

13. The method according to any of claims 9 to 12, wherein the first conductive layer (131) of the top electrode (130) comprises polysilicon, and the second conductive layer (132) of the top electrode (130) comprises tungsten and extends on the first conductive layer (131).
